# EUROPEAN PATENT APPLICATION

(11) **EP 2 061 088 A2**
(43) Date of publication of application: **20.05.2009**
(21) Application number: 08165656.3
(22) Date of filing: 01.10.2008
(51) Int. Cl.: H01L 31/02, H02J 7/35, G08B 25/01, G08B 25/06, G08B 25/10

(54) **Upgraded photovoltaic system**

(30) Priority: 16.11.2007 IT MO20070344
(71) Applicant: Meta System S.p.A., 42100 Reggio Emilia (IT)
(72) Inventor: Simonazzi, Giuseppe, 42100, Reggio Emilia (IT)
(74) Representative: Feltrinelli, Secondo Andrea

(57) **Abstract**

The upgraded photovoltaic system comprises at least a photovoltaic cell, a management unit suitable for distributing and/or storing the electricity generated by photovoltaic effect by the photovoltaic cell, a power line connecting the management unit to the photovoltaic cell, and a monitoring unit suitable for detecting the malfunction, tampering and/or theft of the photovoltaic cell.

## Description

This invention relates to an upgraded photovoltaic system.

Within the field of the production of electricity, the growing use is known of photovoltaic modules, i.e., devices able to convert the sun's energy into electricity by means of photovoltaic effect.

Such photovoltaic modules are generally made of a plurality of photovoltaic cells and are connected the one to the other to define electrically-isolated and self-sufficient (so-called island system) photovoltaic systems or else connected to the national power grid.

The photovoltaic systems of known type do however have a number of drawbacks.

In particular, the photovoltaic cells can be subject to faults, to a reduction in efficiency or, considering the far from negligible costs, they can be subject to thefts.

Each of the photovoltaic modules therefore requires suitable control systems or, in any case, periodical checks on the part of maintenance operators which are not always prompt.

The main aim of the present invention is to provide an upgraded photovoltaic system that allows the continuous control of each of the photovoltaic cells installed on the modules.

Another object of the present invention is to provide an upgraded photovoltaic system that allows overcoming the mentioned drawbacks of the state of the art within a simple, rational solution that is easy and effective to use and of low cost.

The above objects are all achieved by this upgraded photovoltaic system, comprising at least a photovoltaic cell, at least a management unit suitable for distributing and/or storing the electricity generated by photovoltaic effect by said photovoltaic cell, and at least a power line connecting said management unit to said photovoltaic cell, characterized by the fact that it comprises at least a monitoring unit suitable for detecting the malfunction, tampering and/or theft of said photovoltaic cell.

Other features and advantages of this invention will appear clearer from the description of a preferred, but not sole embodiment, of an upgraded photovoltaic system, shown by way of example, but not limited to, on the attached drawing table in which:

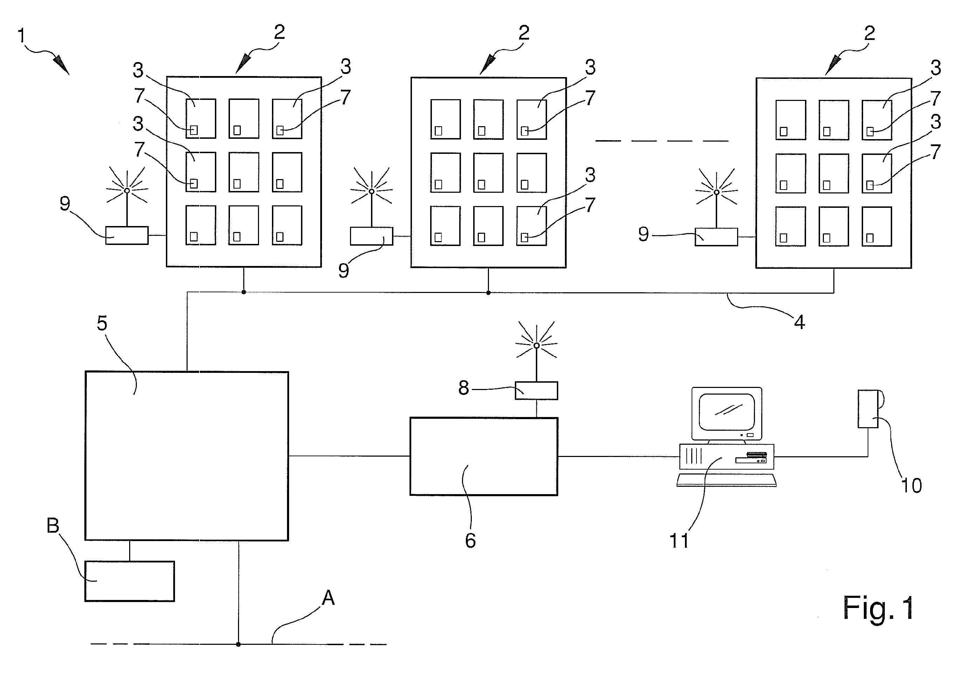

the figure 1 is a general functional diagram of the upgraded photovoltaic system according to the invention.

With particular but not limited reference to the invention as shown in the figure 1, globally indicated by 1 is an upgraded photovoltaic system.

The system 1 can comprise several photovoltaic modules 2, each of which with a plurality of photovoltaic cells 3.

The photovoltaic modules 2 are connected, by means of a power line 4, to a management unit 5 suitable for storing or distributing the electricity generated by photovoltaic effect by each of the photovoltaic cells 3.

In particular, the system 1 can be of the type connected to an external power network A suitable for conveying alternate current to power utilities (e.g., the national power grid). In such case, the management unit 5 comprises a device for transforming the electricity in the form of direct current from the power line 4 and produced by the photovoltaic cells 3 into alternate electric current to be supplied to the external power network A.

Usefully, such transformation device can be composed of an inverter specifically designed to transform the electricity obtained by photovoltaic effect.

In the event of its being necessary to store a part of the power generated by photovoltaic effect, e.g. in the case of the system 1 being used to supply power utilities isolated from other power sources, the management unit 5 can be associated with one or more storage batteries B for storing the electricity produced in excess and not immediately used.

Advantageously, the system 1 comprises a monitoring unit 6 suitable for detecting any faults and/or tampering with the photovoltaic cells 3.

In particular, the use of the monitoring unit 6 allows detecting, in real time, any faults in the photovoltaic cells 3 due, e.g., to manufacturing defects or to a gradual loss of efficiency.

Furthermore, the monitoring unit 6 allows detecting and promptly indicating any tampering or thefts of the photovoltaic cells 3.

Advantageously, the system 1 comprises means of communication between the monitoring unit 6 and each of the photovoltaic cells 3.

Such means of communication comprise a plurality of first communication devices, indicated in figure 1 by the reference 7, that are associated with each of the photovoltaic cells 3 respectively.

The first communication devices 7 can comprise a radio-frequency two-way radio of the type of a transponder or the like and are suitable for transmitting, when interrogated, a univocal identification signal of the photovoltaic cell 3 with which they are associated.

With reference, but not limited to the particular embodiment of the system 1 shown in figure 1, the above means of communication comprise a second communication device 8, associated with the monitoring unit 6, and further transmitting/receiving devices 9 associated with respective photovoltaic modules 2.

Each of the transmitting/receiving devices 9 is suitable for receiving the signals from all the first communication devices 7 present on the respective photovoltaic module 2, and is suitable for conveying such received signals and transmitting them towards the second communication device 8.

Similarly, each of the transmitting/receiving devices 9 is suitable for receiving the signals coming from the second communication device 8 and transmitting the signals thus received to all the first communication devices 7 on the photovoltaic module 2.

Usefully, the second communication device 8 has a radio-frequency two-way radio.

The transmitting/receiving device 9 can have a radio-frequency two-way radio for communicating from/to the photovoltaic cells 3, and a further radio-frequency two-way radio for communicating from/to the monitoring unit 6.

Different embodiments of the means of communication cannot however be ruled out that envisage, e.g., the sending and receiving of radio-frequency signals directly between all the first communication devices 7 on the photovoltaic cells 3 and the second communication device 8 on the monitoring unit 6.

Furthermore, as an alternative to the solution shown in figure 1, the transmitting/receiving device 9 could be equipped with modulation/demodulation means suitable for transforming and sending/receiving, through the power line 4, the signals received from the first communication devices 7 of the photovoltaic cells 3.

The monitoring unit comprises means for processing the identification signals transmitted by the first communication devices 7 and received by the second communication device 8, for the detection of any malfunctions, tampering and/or theft of each single photovoltaic cell 3 or an entire photovoltaic module 2.

Usefully, the monitoring unit 6 is associated with the management unit 5 and has comparison means for comparing the intensity of the total electricity generated by the photovoltaic cells 3 and entering the management unit 5 with a minimum reference value.

Such comparison means make it possible to evaluate any drops in efficiency of the photovoltaic cells 3.

In particular, several minimum reference values can be calculated by making a weighted average of the electricity intensity values detected previously at management unit 5 input, at predetermined hours of the day.

Alternatively, the minimum reference value can be calculated starting with the intensity of the light detected by at least a light sensor 10.

Usefully, the monitoring unit 6 can be associated with one or more processing stations 11, of the type of a personal computer or the like, suitable for processing and displaying the data collected by the monitoring unit to make them more easily usable by an operator.

As shown in figure 1, the light sensor 10 can be associated with the processing station 11. Different solutions cannot however be ruled out in which the light sensor 10 is associated with the monitoring unit 6 or in which there are several light sensors 10 associated with respective photovoltaic modules 2.

The operation of the system 1 is as follows.

The electricity produced by the photovoltaic cells 3, in the form of direct current, is conveyed and introduced onto the power line 4, towards the management unit 5 which distributes and/or stores the excess energy not immediately used.

The monitoring unit 6 interrogates each of the photovoltaic cells 3 at regular intervals, sending a radio-frequency signal by means of the second communication device 8 towards the transmitting/receiving device 9.

The signal thus received from each of the transmitting/receiving devices 9 is then sent towards all the first communication devices 7 (transponder) of the photovoltaic cells 3 on the respective photovoltaic modules 2.

Each of the photovoltaic cells 3 responds by means of the respective first communication device 7, sending an identification signal towards the transmitting/receiving device 9. All the signals received are then conveyed by the transmitting/receiving device and afterwards sent to the second communication device 8 of the monitoring unit 6.

Starting with the identification signals received, the monitoring unit processes and signals any absence and/or malfunction of one or more photovoltaic cells 3.

In particular, this signalling can be done by sending a warning signal to the processing station 11.

The monitoring unit 6, furthermore, makes an evaluation of the efficiency of each photovoltaic module 2 by means of the comparison means with a minimum reference value of the intensity of the total electricity generated by the photovoltaic cells 3 and present at the input of the management unit 5.

It has in point of fact been found how the described invention achieves the proposed objects and, in particular, the fact is underlined that the photovoltaic system according to the invention allows the continuous control by means of the monitoring unit of each of the photovoltaic cells installed on the modules.

This permits promptly signalling any faults or thefts of the single photovoltaic cells.

The invention thus conceived is susceptible to numerous modifications and variations, all of which falling within the scope of the inventive concept.

Furthermore all the details can be replaced with others that are technically equivalent.

In practice, the materials used, as well as the contingent shapes and dimensions, may be any according to requirements without because of this moving outside the protection scope of the following claims.

## Claims

1. Upgraded photovoltaic system, comprising at least a photovoltaic cell, at least a management unit suitable for distributing and/or storing the electricity generated by photovoltaic effect by said photovoltaic cell, and at least a power line connecting said management unit to said photovoltaic cell, **characterized by** the fact that it comprises at least a monitoring unit suitable for detecting the malfunction, tampering and/or theft of said photovoltaic cell.

2. Photovoltaic system according to claim 1, **characterized by** the fact that it comprises means of communication between said monitoring unit and said photovoltaic cell.

3. Photovoltaic system according to one or more of the preceding claims, **characterized by** the fact that said means of communication comprise at least a first communication device associated with said photovoltaic cell and suitable for transmitting at least an identification signal of said photovoltaic cell.

4. Photovoltaic system according to one or more of the preceding claims, **characterized by** the fact that said first communication device comprises at least a radio-frequency two-way radio.

5. Photovoltaic system according to one or more of the preceding claims, **characterized by** the fact that said first communication device is of the type of a transponder or the like.

6. Photovoltaic system according to one or more of the preceding claims, **characterized by** the fact that said means of communication comprise at least a second communication device associated with said monitoring unit.

7. Photovoltaic system according to one or more of the preceding claims, **characterized by** the fact that the monitoring unit comprises means for processing said identification signal transmitted by said first communication device and received by said second communication device, for the detection of any malfunctions, tampering and/or theft of said photovoltaic cell.

8. Photovoltaic system according to one or more of the preceding claims, **characterized by** the fact that said second communication device comprises at least a radio-frequency two-way radio.

9. Photovoltaic system according to one or more of the preceding claims,
**characterized by** the fact that said means of communication comprise at least a transmitting/receiving device suitable for receiving the signals from said first communication device and transmitting them towards said second communication device, or vice versa.

10. Photovoltaic system according to one or more of the preceding claims, **characterized by** the fact that said transmitting/receiving device comprises at least a radio-frequency two-way radio.

11. Photovoltaic system according to one or more of the preceding claims, **characterized by** the fact that said monitoring unit is associated with said management unit.

12. Photovoltaic system according to one or more of the preceding claims, **characterized by** the fact that said transmitting/receiving device comprises modulation/demodulation means suitable for sending/receiving signals through said power line.

13. Photovoltaic system according to one or more of the preceding claims, **characterized by** the fact that said monitoring unit comprises comparison means for comparing the intensity of the total electricity entering said management unit with at least a minimum reference value.

14. Photovoltaic system according to one or more of the preceding claims, **characterized by** the fact that said minimum reference value is calculated starting with at least an electricity intensity value detected previously at management unit input, at a predetermined hour of the day.

15. Photovoltaic system according to one or more of the preceding claims, **characterized by** the fact that said minimum reference value is calculated starting with the intensity of the light detected by at least a light sensor.

16. Photovoltaic system according to one or more of the preceding claims, **characterized by** the fact that it comprises at least a photovoltaic module with a plurality of photovoltaic cells, each of said photovoltaic cells being associated with a respective first communication unit.

17. Photovoltaic system according to one or more of the preceding claims, **characterized by** the fact that said photovoltaic module is associated with said transmitting/receiving device.

18. Photovoltaic system according to one or more of the preceding claims, **characterized by** the fact that it comprises a plurality of photovoltaic modules, each of said photovoltaic modules being associated with a respective transmitting/receiving device.

19. Photovoltaic system according to one or more of the preceding claims, **characterized by** the fact that said monitoring unit can be associated with at least a processing station.

20. Photovoltaic system according to one or more of the preceding claims, **characterized by** the fact that said processing station is of the type of a personal computer or the like.

21. Photovoltaic system according to one or more of the preceding claims, **characterized by** the fact that said light sensor is associated with at least one from said monitoring unit, said processing station and said photovoltaic module.

22. Photovoltaic system according to one or more of the preceding claims, **characterized by** the fact that said management unit comprises at least an electronic device for transforming the direct electric current in input into alternate electric current in output.

23. Photovoltaic system according to one or more of the preceding claims, **characterized by** the fact that said electronic device for transforming is of the type of an inverter or the like.

24. Photovoltaic system according to one or more of the preceding claims, **characterized by** the fact that said management unit can be associated with at least a storage battery for storing the electricity produced in excess.
